# EUROPEAN PATENT APPLICATION

(11) **EP 4 471 879 A1**
(43) Date of publication of application: **04.12.2024**
(21) Application number: 23802480.6
(22) Date of filing: 10.03.2023
(51) Int. Cl.: H01L 33/00

(54) **MICRO LIGHT-EMITTING DIODE DISPLAY SCREEN AND PREPARATION METHOD**

(30) Priority: 12.05.2022 CN 202210514573
(71) Applicant: Huawei Technologies Co., Ltd., Shenzhen, Guangdong 518129 (CN)
(72) Inventor: LUO, Kun, Shenzhen, Guangdong 518129 (CN); JIANG, Congbiao, Shenzhen, Guangdong 518129 (CN); ZHANG, Cuiping, Shenzhen, Guangdong 518129 (CN)
(74) Representative: Goddar, Heinz J.
(86) International application number: PCT/CN2023/080767
(87) International publication number: WO 2023/216704

(57) **Abstract**

This application provides a micro light emitting diode display screen and a preparation method. The display screen includes: a micro light emitting diode array substrate, where a plurality of pixels are set in the micro light emitting diode array substrate, and the plurality of pixels include at least a first subpixel and a second subpixel; a light scattering structure, prepared above the first subpixel, and configured to scatter first emitting light generated by the first subpixel; a light conversion structure, prepared above the second subpixel, and configured to convert second emitting light generated by the second subpixel; and a metal isolation structure, prepared between the light scattering structure and the light conversion structure, where the light scattering structure, the light conversion structure, and the metal isolation structure are located at a same layer. This can effectively improve light emitting efficiency and provide a good heat dissipation effect.

## Description

This application claims priority to Chinese Patent Application No. 202210514573.0, filed with the China National Intellectual Property Administration on May 12, 2022 and entitled "MICRO LIGHT EMITTING DIODE DISPLAY SCREEN AND PREPARATION METHOD", which is incorporated herein by reference in its entirety.

### TECHNICAL FIELD

This application relates to the field of displaying technologies, and in particular, to a micro light emitting diode display screen and a preparation method.

### BACKGROUND

With continuous development of the displaying field, micro light emitting diode (Micro Light Emitting Diode, MicroLED) optical receivers/transmitters are more widely used in the field of small-size displaying. For example, in augmented reality glasses (Augmented Reality Glasses, AR Glasses), a displaying manner of the glasses is that a MicroLED optical receiver/transmitter with high brightness, a small size, and a long service life and a diffractive waveguide combiner jointly perform displaying. However, due to a limitation of a physical feature of a material of a red light MicroLED, in a scenario in which a red light LED is prepared by using a material of a red light MicroLED with a small size, light emitting efficiency of the red light MicroLED is sharply reduced, and a displaying effect is greatly affected. Therefore, in the conventional technology, a red light subpixel is usually prepared by using a material of a blue light MicroLED or an ultraviolet light MicroLED, and then a light conversion material of red light is excited to convert blue light or ultraviolet light into the red light for outward emitting.

However, in a MicroLED display screen, for example, a MicroLED display screen in the AR glasses that is of a displaying structure with a small size, high pixel density, high brightness, and concentrated heat, effects of high pixel density, high brightness, and fast heat dissipation cannot be simultaneously achieved. Therefore, in a full-color MicroLED micro display screen, how to increase brightness and ensure fast heat dissipation while implementing a high pixel is an urgent problem to be resolved.

### SUMMARY

Embodiments of this application provide a micro light emitting diode display screen and a preparation method, to effectively improve light emitting efficiency and provide a good heat dissipation effect.

According to a first aspect, an embodiment of this application provides a micro light emitting diode display screen, including: a micro light emitting diode array substrate, where a plurality of pixels are set in the micro light emitting diode array substrate, and the plurality of pixels each include at least a first subpixel and a second subpixel; a light scattering structure, prepared above the first subpixel, and configured to scatter first emitting light generated by the first subpixel; a light conversion structure, prepared above the second subpixel, and configured to convert second emitting light generated by the second subpixel; and a metal isolation structure, prepared between the light scattering structure and the light conversion structure, where the light scattering structure, the light conversion structure, and the metal isolation structure are located at a same layer.

When the micro light emitting diode display screen is driven by a circuit, the plurality of pixels set in the micro light emitting diode array substrate in the micro light emitting diode display screen may display colors under circuit driving. Each pixel includes subpixels with primary colors, and the subpixels are usually subpixels with three primary colors of red, green, and blue. In the field of small-size displaying, sometimes, a red or green subpixel needs to be prepared after a blue light subpixel is prepared by using a blue preparation material, and a color of the generated second emitting light is converted, by using the light conversion structure, into red or green required for displaying. This subpixel is denoted as the second subpixel. Based on a feature that light conversion needs to be performed on the second subpixel, the light conversion structure needs to be prepared above the second subpixel to perform light conversion on the second emitting light. When some other subpixels are prepared, light conversion does not need to be performed. For example, a blue light subpixel needs to be prepared by using a blue preparation material. This subpixel may be denoted as the first subpixel. The light scattering structure needs to be prepared above the first subpixel, for example, the blue light subpixel, and the first emitting light of the blue light subpixel is scattered in the light scattering structure, so that the first emitting light is scattered, for light emitting, at a position at which the display screen most needs to emit light. In this way, light with three primary colors required by the display screen for color display can be obtained.

To avoid a case in which when a light ray emitted by a subpixel is scattered in the light conversion structure or the light scattering structure, the emitted light ray is scattered at a position other than a light emitting position, affecting light emitting efficiency of the light emitting position, in this embodiment of this application, the metal isolation structure is prepared between the light conversion structure and the light scattering structure. The metal isolation structure may reflect the scattered light ray back to the light scattering structure or the light conversion structure, then refract the light ray, and finally emit the light ray at the light emitting position. In this way, the light emitting efficiency is effectively improved.

In a general process of preparing the display screen, a dielectric material is filled between the light scattering structure and the light conversion structure. Because the dielectric material has a poor heat-conducting property and a poor heat dissipation effect, a temperature gradually increases when a pixel emits light, and a high temperature reduces stability of the light conversion material. In the display screen provided in this application, the dielectric material is replaced by the metal isolation structure, and the metal isolation structure is disposed between the light scattering structure and the light conversion structure, so that a heat-conducting property of a metal can be used to greatly improve the heat dissipation effect of the display screen, and improve stability of the light conversion material, to further improve a displaying effect of the display screen.

In a possible implementation, a metal reflection layer wraps around side surfaces and bottom surfaces of the first subpixel and the second subpixel.

Similarly, based on a light reflection property of the metal, that the metal reflection layer wraps around the side surfaces and the bottom surfaces of each first subpixel and each second subpixel may improve light efficiency and reduce optical crosstalk between the subpixels. Compared with the conventional technology in which a dielectric material is deposited between subpixels, in this application, the added metal reflection layer can also relatively improve the heat dissipation effect.

In a possible implementation, the display screen further includes: a circuit backplane, bonded with the micro light emitting diode array substrate, and configured to: drive the first subpixel to generate the first emitting light and drive the second subpixel to generate the second emitting light.

After the circuit backplane is bonded with the micro light emitting diode array substrate, circuit driving can be provided according to a displaying requirement, so that the first subpixel and the second subpixel in the micro light emitting diode array substrate emit light based on different types of driving. Further, the display screen can display colors, and a complete micro light emitting diode display screen with the foregoing beneficial effects can be formed.

In a possible implementation, the micro light emitting diode array substrate includes a plurality of electrodes electrically connected to the circuit backplane, the plurality of electrodes are connected to supply power, one first subpixel or one second subpixel is correspondingly prepared on each electrode, a dielectric layer is deposited between the side surfaces of the first subpixel and the second subpixel and the metal reflection layer, and the metal reflection layer on the bottom surfaces of the first subpixel and the second subpixel is connected to the electrode.

Further, the micro light emitting diode array substrate includes a micro light emitting diode array, the micro light emitting diode array includes a plurality of pixels, and the pixels each include the first subpixel and the second subpixel. The display screen of this structure not only has a simple preparation process, but also can effectively improve light emitting efficiency of the micro light emitting diode array, the light scattering structure, and the light conversion structure, so that screen display brightness can be increased, and a good heat dissipation effect can be further provided.

In a possible implementation, each pixel includes two first subpixels and one second subpixel. One of the first subpixels is a green light subpixel on which a green light indium gallium nitride micro light emitting diode is prepared, the other one of the first subpixels is a blue light subpixel on which a blue light indium gallium nitride micro light emitting diode is prepared, and the second subpixel is a red light subpixel on which the blue light indium gallium nitride micro light emitting diode is prepared. In a possible implementation, each pixel includes one first subpixel and two second subpixels. The first subpixel is a blue light subpixel on which a blue light indium gallium nitride micro light emitting diode is prepared, one of the second subpixels is a red light subpixel on which the blue light indium gallium nitride micro light emitting diode is prepared, and the other one of the second subpixels is a green light subpixel on which the blue light indium gallium nitride micro light emitting diode is prepared.

In some instances, the red light subpixel may alternatively be implemented by performing light conversion after a light emitting diode of ultraviolet light is prepared. Similarly, the green light subpixel and the blue light subpixel may alternatively be obtained by preparing subpixels with other colors. In this application, a subpixel on which light conversion needs to be performed is used as the first subpixel, and a subpixel on which light conversion does not need to be performed is used as the second subpixel. However, an indium gallium nitride micro light emitting diode to be used by each subpixel to grow is not limited. The prepared micro light emitting diode array basically includes a micro light emitting diode array. The micro light emitting diode array may include a plurality of pixels, each pixel includes three subpixels: red, green, and blue, and a size and a pixel spacing of each pixel may be controlled within a specific range. When a size of a subpixel is allocated, a pixel area of a subpixel with low light conversion efficiency is increased in consideration of light conversion efficiency, so that overall brightness of the display screen can be ensured.

In a possible implementation, a size of the second subpixel adapts to conversion efficiency of a light conversion material in the corresponding light conversion structure.

The light conversion efficiency not only affects the allocated size of the subpixel, but also needs to adapt to the light conversion structure prepared above the subpixel, namely, the second subpixel, on which light conversion needs to be performed. In other words, if conversion efficiency of the light conversion material in the light conversion structure is low, a size of the light conversion structure should also be correspondingly increased, to ensure light emitting efficiency and further ensure overall brightness of the display screen.

In a possible implementation, the display screen further includes an encapsulation layer, located on the light scattering structure, the light conversion structure, and the metal isolation structure that are located at the same layer.

Preparing the encapsulation layer can effectively prevent external impact on the display screen, for example, interference caused by corrosion and moisture to a structure of the display screen, and prolong a service life.

In a possible implementation, the display screen further includes a microlens array, prepared on the encapsulation layer, where the microlens array includes a plurality of microlenses, and each microlens is correspondingly disposed above the light scattering structure or the light conversion structure.

After the encapsulation layer is prepared, a divergence angle of a pixel may be reduced by preparing the microlens array. In other words, collimation of a light ray is improved, so that more light rays are concentrated at a small angle for emitting.

In a possible implementation, the display screen further includes: a transparent electrode, deposited above the first subpixel and the second subpixel.

The transparent electrode is divided into different electrodes according to a requirement that the display screen is co-cathode or co-anode, and drives pixel color display together with the electrode of the circuit backplane.

According to a second aspect, an embodiment of this application provides a micro light emitting diode display screen preparation method, including: preparing a micro light emitting diode array substrate, where a plurality of pixels are set in the micro light emitting diode array substrate, and the plurality of pixels each include at least a first subpixel and a second subpixel; and preparing a metal isolation structure, a light scattering structure, and a light conversion structure at a same layer of the micro light emitting diode array substrate, where the metal isolation structure is prepared between the light scattering structure and the light conversion structure, the light scattering structure configured to scatter first emitting light generated by the first subpixel is prepared above the first subpixel, and the light conversion structure configured to convert second emitting light generated by the second subpixel is prepared above the second subpixel.

In a possible implementation, the preparing a micro light emitting diode array substrate includes: preparing a micro light emitting diode array, where the micro light emitting diode array includes a plurality of pixels, and the pixels each include the first subpixel and the second subpixel; depositing a dielectric layer on the micro light emitting diode array; depositing a metal at an etched dielectric layer, to obtain a metal reflection layer wrapping around side surfaces and lower surfaces of the first subpixel and the second subpixel, where there is the deposited dielectric layer between the side surface of the subpixel and the metal reflection layer; and etching the metal reflection layer on the lower surface of the subpixel, to enable the metal reflection layer to form ohmic contact with an electrode above the metal reflection layer.

In a possible implementation, after the preparing a micro light emitting diode array substrate, the method further includes: bonding the micro light emitting diode array substrate on a circuit backplane, to enable the circuit backplane to drive the first subpixel to generate the first emitting light and drive the second subpixel to generate the second emitting light.

In a possible implementation, the preparing a micro light emitting diode array substrate includes: preparing a plurality of pixels that each include two first subpixels and one second subpixel, where preparing the two first subpixels includes preparing one green light subpixel by growing a green light indium gallium nitride micro light emitting diode and preparing one blue light subpixel by growing a blue light indium gallium nitride micro light emitting diode, and preparing the second subpixel includes preparing one red light subpixel by growing the blue light indium gallium nitride micro light emitting diode.

In a possible implementation, the preparing a micro light emitting diode array substrate includes: preparing a plurality of pixels that each include one first subpixel and two second subpixels, where preparing the first subpixel includes preparing one blue light subpixel by growing a blue light indium gallium nitride micro light emitting diode, and preparing the two second subpixels includes preparing one red light subpixel by growing the blue light indium gallium nitride micro light emitting diode and preparing one green light subpixel by growing the blue light indium gallium nitride micro light emitting diode.

In a possible implementation, after the preparing a micro light emitting diode array substrate, the method further includes: bonding the micro light emitting diode array substrate on the circuit backplane, where a plurality of electrodes connected for power supply in the micro light emitting diode are electrically connected to the circuit backplane, one first subpixel or one second subpixel is correspondingly prepared on each electrode, the dielectric layer is deposited between the side surfaces of the first subpixel and the second subpixel and the metal reflection layer, and the metal reflection layer on the bottom surfaces of the first subpixel and the second subpixel is connected to the electrode, to enable the circuit backplane to drive the first subpixel and the second subpixel to emit light.

In a possible implementation, after the preparing a metal isolation structure, a light scattering structure, and a light conversion structure at a same layer of the micro light emitting diode array substrate, the method further includes: preparing an encapsulation layer on the light scattering structure, the light conversion structure, and the metal isolation structure that are located at the same layer.

In a possible implementation, after the preparing an encapsulation layer on the light scattering structure, the light conversion structure, and the metal isolation structure that are located at the same layer, the method further includes: disposing a microlens at a position that is at the encapsulation layer and that is corresponding to the light scattering structure or the light conversion structure, where a plurality of microlenses form a microlens array.

In a possible implementation, a size of the second subpixel adapts to conversion efficiency of a light conversion material in the corresponding light conversion structure.

In a possible implementation, before the preparing a metal isolation structure, a light scattering structure, and a light conversion structure at a same layer of the micro light emitting diode array substrate, the method further includes: depositing a transparent electrode above the first subpixel and the second subpixel.

In a possible implementation, the preparing a metal isolation structure includes: preparing the metal isolation structure on the transparent electrode through physical vapor deposition; preparing the metal isolation structure on the transparent electrode in an electroplating manner; or spin-coating a photoresist on the transparent electrode, preparing inverted trapezoid structures above the micro light emitting diode array through exposing and developing, and preparing the metal isolation structure between the inverted trapezoid structures in an electroplating manner.

It should be understood that, technical solutions in the second aspect of this application are consistent with technical solutions in the first aspect of this application. Beneficial effects achieved by the aspects and corresponding feasible implementations are similar. Details are not described again.

### BRIEF DESCRIPTION OF DRAWINGS

FIG. 1 is a schematic diagram of a structure of a MicroLED display screen according to an embodiment of this application;
FIG. 2 is a schematic diagram of another structure of a MicroLED display screen according to an embodiment of this application;
FIG. 3 is a sectional view of a MicroLED array substrate according to an embodiment of this application;
FIG. 4 is a schematic diagram of another structure of a MicroLED display screen according to an embodiment of this application;
FIG. 5 is a schematic flowchart of a MicroLED display screen preparation method according to an embodiment of this application;
FIG. 6 is a schematic flowchart of a MicroLED array substrate preparation method according to an embodiment of this application;
FIG. 7 is a schematic diagram of a structure of pixel arrangement of a MicroLED array;
FIG. 8 is a bonding diagram of a circuit backplane and a MicroLED array substrate according to an embodiment of this application;
FIG. 9A is a preparation flowchart of preparing a metal isolation structure according to an embodiment of this application;
FIG. 9B is a preparation flowchart of preparing a metal isolation structure according to an embodiment of this application;
FIG. 9C is another preparation flowchart of preparing a metal isolation structure according to an embodiment of this application; and
FIG. 10 is a schematic diagram of another structure of pixel arrangement of a MicroLED array according to an embodiment of this application.

### DESCRIPTION OF EMBODIMENTS

The following clearly and completely describes the technical solutions in embodiments of this application with reference to the accompanying drawings in embodiments of this application. It is clear that the described embodiments are some but not all of embodiments of this application. All other embodiments obtained by a person of ordinary skill in the art based on embodiments of this application without creative efforts shall fall within the protection scope of this application.

The term "and/or" in this specification describes only an association relationship for describing associated objects and represents that three relationships may exist. For example, A and/or B may represent the following three cases: only A exists, both A and B exist, and only B exists.

In descriptions of embodiments of this application, unless otherwise clearly specified and limited, the terms "first" and "second" are used only for description and cannot be understood as an indication or implication of relative importance. Unless otherwise specified or stated, the term "a plurality of" means two or more than two. The term "connection", "fastening", or the like should be understood in a broad sense. For example, "connection" may be a fixed connection, or may be a detachable connection, an integral connection, or an electrical connection, or may be a direct connection, or may be an indirect connection performed by using an intermediate medium. For a person of ordinary skill in the art, specific meanings of the foregoing terms in this application may be understood based on a specific situation.

In the descriptions of this specification, it should be understood that orientation words such as "above" and "below" described in embodiments of this application are described from the perspective shown in the accompanying drawings, and should not be construed as a limitation on embodiments of this application. In addition, in the context, it also should be understood that, when it is mentioned that one element is connected "above" or "below" another element, the element can be directly connected "above" or "below" the another element, and may be indirectly connected "above" or "below" the another element through an intermediate element.

In addition, in embodiments of this application, the word "example" or "for example" represents giving an example, an illustration, or a description. Any embodiment or design scheme described as "example" or "for example" in embodiments of this application should not be explained as being more preferred or having more advantages than another embodiment or design scheme. Exactly, use of the word "example", "for example", or the like is intended to present a related concept in a specific manner.

In the descriptions of embodiments of this application, unless otherwise stated, "a plurality of" means two or more than two. The following describes this application in detail with reference to the accompanying drawings and embodiments. It should be understood that the specific embodiments described herein are only for explaining this application but are not intended to limit this application.

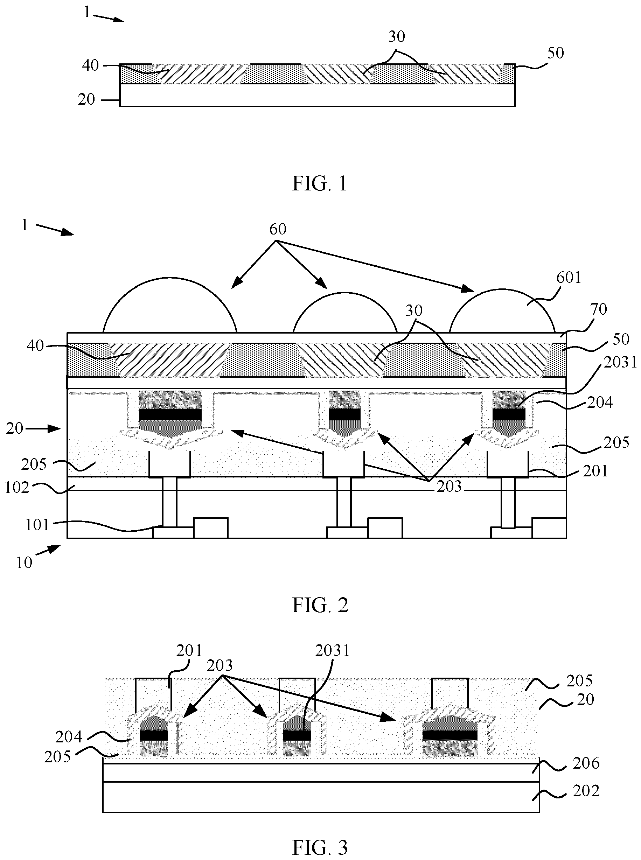

An embodiment of this application provides a micro light emitting diode display screen, which is denoted as a MicroLED display screen below. FIG. 1 is a schematic diagram of a structure of a MicroLED display screen according to an embodiment of this application. As shown in FIG. 1, the MicroLED display screen 1 includes a micro light emitting diode array substrate 20, a light scattering structure 30, a light conversion structure 40, and a metal isolation structure 50.

A plurality of pixels are set in the micro light emitting diode array substrate 20, and the plurality of pixels each include at least a first subpixel and a second subpixel. In general, subpixels with primary colors in each pixel are usually subpixels with three primary colors of red, green, and blue. Each pixel provided in this application may include three subpixels. In a case, each pixel includes two first subpixels and one second subpixel. In another case, each pixel includes one first subpixel and two second subpixels. The first subpixel is a subpixel on which light conversion does not need to be performed, for example, a subpixel whose color of a material for growing a light emitting diode is consistent with a color of required emitting light. The second subpixel is a subpixel on which light conversion needs to be performed, for example, a subpixel whose color of a material for growing a light emitting diode is different from a color of required emitting light.

The MicroLED display screen 1 includes: the light scattering structure 30, prepared above the first subpixel, and configured to scatter first emitting light generated by the first subpixel; the light conversion structure 40, prepared above the second subpixel, and configured to convert second emitting light generated by the second subpixel; and the metal isolation structure 50, prepared between the light scattering structure 30 and the light conversion structure 40, and configured to reflect the first emitting light and the second emitting light to corresponding light emitting positions, to effectively dissipate heat. The light scattering structure 30, the light conversion structure 40, and the metal isolation structure 50 are located at a same layer of the MicroLED display screen 1.

Further, FIG. 2 is a schematic diagram of another structure of the MicroLED display screen according to an embodiment of this application. As shown in FIG. 2, the MicroLED display screen 1 further includes a circuit backplane 10, a transparent electrode 60, and an encapsulation layer 70. The circuit backplane 10 bonded with the micro light emitting diode array substrate 20 is configured to: drive the first subpixel to generate the first emitting light and drive the second subpixel to generate the second emitting light. After the circuit backplane of the MicroLED display screen is bonded with the MicroLED array substrate, circuit driving can be provided according to a displaying requirement, so that a MicroLED array in the MicroLED array substrate displays colors based on different types of driving. The MicroLED array includes a plurality of pixels, and subpixels with primary colors in each pixel are usually subpixels with three primary colors of red, green, and blue. In the field of small-size displaying, sometimes, a red or green subpixel needs to be prepared after a blue light subpixel is prepared by using a blue preparation material, and a color of the generated second emitting light is converted, by using the light conversion structure, into red or green required for displaying. This subpixel is denoted as the second subpixel. Based on a feature that light conversion needs to be performed on the second subpixel, the light conversion structure needs to be prepared above the second subpixel to perform light conversion on the second emitting light. When some other subpixels are prepared, light conversion does not need to be performed. For example, a blue light subpixel needs to be prepared by using a blue preparation material. This subpixel may be denoted as the first subpixel. The light scattering structure needs to be prepared above the first subpixel, for example, the blue light subpixel, and the first emitting light of the blue light subpixel is scattered in the light scattering structure, so that the first emitting light is scattered, for light emitting, at a position at which the display screen most needs to emit light. In this way, light with three primary colors required by the display screen for color display can be obtained. To avoid a case in which when a light ray emitted by a subpixel is scattered in the light conversion structure or the light scattering structure, the emitted light ray is scattered at a position other than a light emitting position, affecting light emitting efficiency of the light emitting position, in this embodiment of this application, the metal isolation structure is prepared between the light conversion structure and the light scattering structure. The metal isolation structure may reflect the scattered light ray back to the light scattering structure or the light conversion structure, then refract the light ray, and finally emit the light ray at the light emitting position. In this way, the light emitting efficiency is effectively improved. In a possible manner, the light conversion structure may be obtained by adding a light conversion material to the light scattering structure.

In a process of preparing the display screen, a dielectric material needs to be deposited. Because the dielectric material has a poor heat-conducting property and a poor heat dissipation effect, stability of the light conversion material is reduced. In the display screen in this application, the dielectric material is replaced by the metal isolation structure, and the metal isolation structure is designed between the light scattering structure and the light conversion structure. A metal has a good heat-conducting property, and can greatly improve the heat dissipation effect of the display screen.

Further, the MicroLED array in the MicroLED array substrate 20 includes a plurality of pixels, and a metal reflection layer wraps around a side surface and a bottom surface of each subpixel in the pixel. A metal reflection layer wraps around side surfaces and bottom surfaces of the first subpixel and the second subpixel. Similar to an effect of the metal isolation structure, based on a light reflection property of the metal, that the metal reflection layer wraps around the side surface and the bottom surface of each subpixel may improve light efficiency and reduce optical crosstalk between the subpixels. Compared with the conventional technology in which a dielectric material is deposited between subpixels, in this application, the added metal reflection layer can also relatively improve the heat dissipation effect.

Optionally, the structure of the display screen provided in this application may be shown in FIG. 2. The circuit backplane 10 is bonded with the MicroLED array substrate 20. The MicroLED array substrate 20 includes a plurality of electrodes electrically connected to the circuit backplane 10. The plurality of electrodes are connected to supply power. One subpixel of the MicroLED array is prepared on each electrode. The subpixel may be the first subpixel or the second subpixel. A dielectric layer is deposited between the side surface of each subpixel and the metal reflection layer, the metal reflection layer on the bottom surface of each subpixel is connected to the electrode. The light scattering structure 30 is prepared above the first subpixel, and the light conversion structure 40 is prepared above the second subpixel. The encapsulation layer 70 is prepared on the light scattering structure 30, the light conversion structure 40, and the metal isolation structure 50. The display screen of this structure not only has a simple preparation process, but also can effectively improve light emitting efficiency of the MicroLED array, the light scattering structure, and the light conversion structure, so that screen display brightness can be increased, and a good heat dissipation effect can be further provided.

Further, the MicroLED array substrate includes the MicroLED array, the MicroLED array includes a plurality of pixels, and the pixels each include the first subpixel and the second subpixel. In this embodiment of this application, in an apparatus part, an example in which the first subpixel and the second subpixel are set in a MicroLED is used for description. That the MicroLED array substrate includes the MicroLED array, and the plurality of pixels are set in the MicroLED array is also within a protection scope.

As shown in FIG. 2, the circuit backplane 10 is set at a bottom layer of the MicroLED display screen 1. The circuit backplane 10 often uses a CMOS drive circuit. The CMOS drive circuit is prepared based on a silicon semiconductor technology. The CMOS drive circuit may be prepared based on a mature semiconductor process in the conventional technology. Details are not described in this embodiment of this application.

Some copper electrodes 101 and a dielectric layer 102 deposited around the copper electrodes are disposed on the top of the circuit backplane 10, and silicon dioxide SiO2 and some silicon nitride SiNx films may be selected as materials of the dielectric layer.

The MicroLED array substrate 20 bonded with the circuit backplane 10 is located on the circuit backplane 10. The MicroLED array substrate 20 is formed on a substrate layer by layer. After the MicroLED array substrate 20 is bonded with the circuit backplane 10, the circuit backplane 10 and the MicroLED array substrate 20 are integrated, and an epitaxial substrate is removed to form the structure shown in FIG. 2. The copper electrode 101 corresponding to the CMOS circuit and the electrode in the MicroLED array substrate 20, for example, a copper electrode 201, are aligned with each other and are connected together through copper atom diffusion to form an electrical connection. Dielectric layers in a non-electrode region, namely, the dielectric layer 102 of the circuit backplane 10 and the dielectric layer in the MicroLED array substrate 20 undergo a chemical reaction under a specific temperature and pressure, so that the two interfaces are fused to implement bonding between the MicroLED array substrate 20 and the circuit backplane 10.

After the circuit backplane 10 is bonded with the MicroLED array substrate 20, the electrodes that are electrically connected to the circuit backplane 10 in the MicroLED array substrate 20 are connected to supply power. In this embodiment of this application, an example in which the MicroLED array uses a co-cathode driving manner is used for description. To be specific, a cathode of the MicroLED array is connected to and powered by a same electrode. To be specific, after bonding, the plurality of copper electrodes 201 in the MicroLED array substrate 20 and the corresponding copper electrodes 101 in the circuit backplane 10 are fused into a same electrode, and the copper electrodes are connected to each other and supply power as an anode of the MicroLED array. Similarly, if the MicroLED array 203 uses a co-anode driving manner, to be specific, an anode of the MicroLED array is connected to and powered by a same electrode, the copper electrodes are connected to each other and supply power as a cathode of the MicroLED array.

The MicroLED array 203 may be prepared by using a selective region epitaxial growth technology. For example, on a buffer layer 206 of a same epitaxial substrate 202, an indium gallium nitride InGaN MicroLED is epitaxially grown in a specified region by using a mask template. The MicroLED array 203 may include M*N pixels, where M and N are positive integers. Each pixel may further include three subpixels arranged on a same horizontal plane, for example, two first subpixels and one second subpixel, or two second subpixels and one first subpixel. The subpixels need to display light with three colors of red, green, and blue externally. However, during preparation, due to an obvious advantage of using an InGaN material, blue light and green light InGaN MicroLEDs may be usually prepared, and then a light color that needs to be displayed is obtained by using the light conversion structure. In this application, an example in which a co-cathode MicroLED array substrate is prepared is used. After the MicroLED array 203 is prepared, a dielectric layer needs to be deposited to perform passivation protection on a surface of each subpixel of the MicroLED and perform electrical isolation on each subpixel. Then, a passivation layer on a surface of the MicroLED array 203 is etched to expose an anode region of the MicroLED array 203, and physical vapor deposition is performed on a layer of a metal to make the metal be in contact with P-type GaN of each MicroLED and wrap the MicroLED to form a metal reflection layer at which pixel optical isolation is performed on the MicroLED. If the MicroLED array substrate 20 uses the co-cathode driving manner, the layer of the deposited metal is an anode metal, and graphical processing needs to be performed on the anode metal to avoid an anode short circuit on the MicroLED array substrate 20. The anode metal needs to be protected by using the dielectric material after graphical processing is performed. Gaps between the MicroLEDs may be filled by depositing the dielectric material. Therefore, a dielectric layer is deposited again, and then the dielectric layer is etched to expose the anode of the MicroLED array, so that the copper electrode 201 forms ohmic contact with the anode metal. FIG. 3 is a sectional view of the MicroLED array substrate according to an embodiment of this application. As shown in FIG. 3, the MicroLED array substrate 20 includes the epitaxial substrate 202, the MicroLED array 203 on the epitaxial substrate 202, and the metal reflection layer 204 wrapping around the side surface and the lower surface of each subpixel 2031 of the MicroLED array 203. The metal reflection layer 204 is connected to the copper electrode 201 to supply power after graphical processing is performed. A dielectric layer 205 is deposited between the side surface of each subpixel 2031 and the metal reflection layer 204. The dielectric layer 205 is further deposited between the foregoing MicroLEDs, to be specific, between subpixels 2031 of MicroLED arrays 203. Whether the subpixel 2031 is the first subpixel or the second subpixel may be determined based on an actual preparation material of the display screen and a color required for displaying.

It should be noted that, after the MicroLED array substrate 20 is bonded with the circuit backplane 10, the epitaxial substrate 202 is removed. The circuit backplane 10 is located below the MicroLED array substrate 20, and the MicroLED array substrate 20 is turned over and located on the circuit backplane 10. The copper electrode 201 is fused with the copper electrode 101 of the circuit backplane 10, and the dielectric layer 205 and the dielectric layer 102 of the circuit backplane 10 also undergo a chemical reaction at a specific temperature and pressure, so that the two interfaces are integrated together in a fusing manner. In this case, the sectional view of the structure of the MicroLED array substrate 20 is shown in FIG. 2, where the structure is a structure in which the copper electrode 201 is located below the MicroLED array 202. To be specific, one subpixel 2031 of the MicroLED array 203 is prepared on each copper electrode 201, the metal reflection layer 204 wraps around the side surface and the bottom surface of the subpixel 2031, the dielectric layer 205 is deposited between the side surface of each subpixel and the metal reflection layer, and the metal reflection layer 203 on the bottom surface of each subpixel 2031 is connected to the electrode 201.

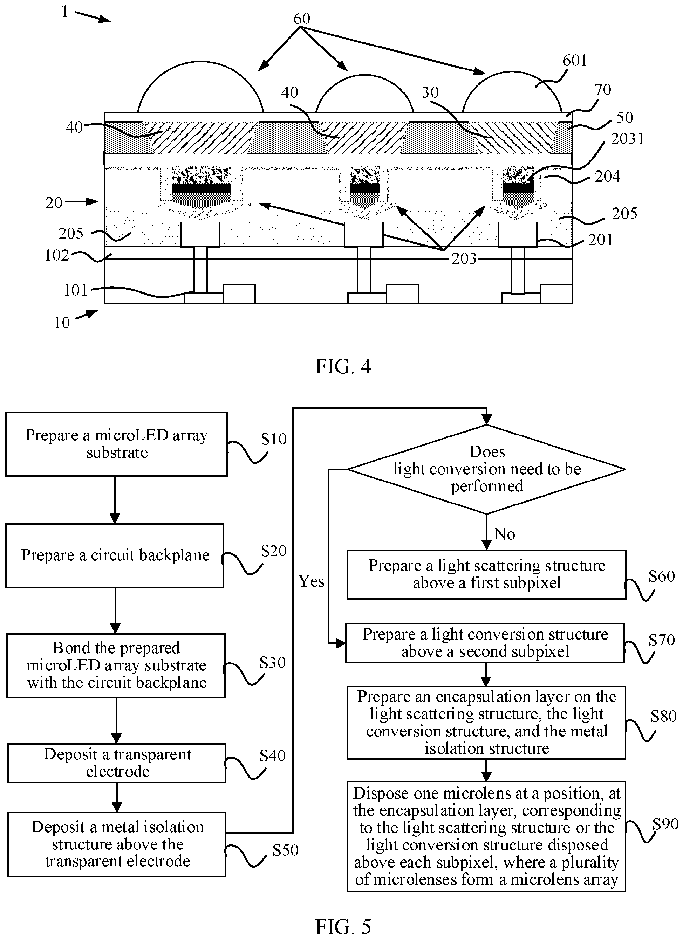

As shown in FIG. 2, on the MicroLED array substrate 20, the light scattering structure 30 is prepared above the first subpixel, and the light conversion structure 40 is prepared above the second subpixel. With reference to the foregoing example, when a MicroLED is prepared, usually, blue light and green light InGaN MicroLEDs may be prepared, and then light conversion is performed, to implement emitting of light with three colors of RGB. It is assumed that three subpixels included in a generated pixel are two first subpixels and one second subpixel, where one of the first subpixels is a green light subpixel on which a green light indium gallium nitride micro light emitting diode is prepared, the other one of the first subpixels is a blue light subpixel on which a blue light indium gallium nitride micro light emitting diode is prepared, and the second subpixel is a red light subpixel on which the blue light indium gallium nitride micro light emitting diode is prepared, namely, a green light subpixel on which the green light indium gallium nitride InGaN MicroLED is prepared, a blue light subpixel on which the blue light InGaN MicroLED is prepared, and another red light subpixel on which the blue light InGaN MicroLED is prepared. It can be determined from a color of grown InGaN and a light color to be output that, light conversion does not need to be performed on the green light subpixel and the blue light subpixel, and light conversion needs to be performed on the red light subpixel. In other words, a light color that needs to be displayed needs to be obtained by using the light conversion structure. As shown in FIG. 2, the light scattering structure 30 is prepared above the green light subpixel and the blue light subpixel, and the light conversion structure 40 is prepared above the red light subpixel. In some instances, each pixel includes three subpixels, and each pixel includes one first subpixel and two second subpixels. The first subpixel is a blue light subpixel on which a blue light indium gallium nitride micro light emitting diode is prepared, one of the second subpixels is a red light subpixel on which the blue light indium gallium nitride micro light emitting diode is prepared, and the other one of the second subpixels is a green light subpixel on which the blue light indium gallium nitride micro light emitting diode is prepared. In other words, descriptions are provided by using an example in which each pixel includes one green light subpixel on which a blue light InGaN MicroLED is prepared, one blue light subpixel on which the blue light InGaN MicroLED is prepared, and one red light subpixel on which the blue light InGaN MicroLED is prepared. FIG. 4 is a schematic diagram of another structure of the MicroLED display screen according to an embodiment of this application. As shown in FIG. 4, light conversion does not need to be performed on the blue light subpixel, light conversion needs to be performed on the green light subpixel and the red light subpixel, the light scattering structure 30 is prepared above the blue light subpixel, and the light conversion structure 40 is prepared above the green light subpixel and the red light subpixel.

In some instances, the red light subpixel may alternatively be implemented by performing light conversion after a light emitting diode of ultraviolet light is prepared. Similarly, the green light subpixel and the blue light subpixel may alternatively be obtained by preparing subpixels with other colors. In this application, a subpixel on which light conversion needs to be performed is used as the first subpixel, and a subpixel on which light conversion does not need to be performed is used as the second subpixel. However, an indium gallium nitride micro light emitting diode to be used by each subpixel to grow is not limited. Further, the transparent electrode 60 is deposited between the subpixel 2031 and the light scattering structure 30 and the light conversion structure 40, the transparent electrode 60 is deposited on the MicroLED array 20, namely, all subpixels 2031, and the light scattering structure 30 or the light conversion structure 40 is prepared above the subpixel corresponding to the transparent electrode 60. An example in which the MicroLED array 20 uses the co-cathode driving manner is still used, the transparent electrode on the subpixel 2031 is a cathode electrode 60. After the transparent electrode 60, which may also be referred to as a transparent cathode, is prepared, the metal isolation structure 50 is then prepared. The metal isolation structure 50 may reflect back light that is scattered at a scattering layer 30 or the light conversion structure 40 towards the metal isolation structure 50, and may also be used as a metal grid after graphical processing is performed, to reduce a resistance of the transparent cathode. The metal isolation structure 50 is prepared between all the light scattering structures 30 and the light conversion structures 40. The light scattering structure 30, the light conversion structure 40, and the metal isolation structure 50 have a same thickness, and the encapsulation layer 70 is further prepared on the light scattering structure 30, the light conversion structure 40, and the metal isolation structure 50. The encapsulation layer 70 may isolate the light conversion structure 40 and the light scattering structure 30 from water vapor and oxygen in the air, to slow down aging speeds of the light conversion structure 40 and the light scattering structure 30. A microlens array 60 may be further prepared on the encapsulation layer 70. The microlens array 60 is located on the encapsulation layer 70, and one microlens 601 is disposed at a position corresponding to the light scattering structure 30 or the light conversion structure 40 disposed above each subpixel 2031. The microlenses 601 form the microlens array 60. The microlens array 60 may reduce a divergence angle of each subpixel 2031, that is, improve collimation of a light ray, so that more light rays are concentrated at a small angle for emitting. In this way, a light emitting effect of the MicroLED display screen is better.

It should be noted that, the metal isolation structure 50 is prepared between each light scattering structure and each light conversion structure, and a shape of the metal isolation structure 50 is similar to a metal isolation block. A section of the metal isolation block is a trapezoid. An angle of inclination between a side edge and a bottom edge of the trapezoid is denoted as β. A value of β may be set based on a size of a corresponding subpixel under the metal isolation block and thicknesses of the metal isolation block and the light scattering structure or the light conversion structure, and the light scattering structure and the light conversion structure have a same thickness. In general, the β angle ranges from 15° to 80°. The angle may be adjusted based on the size of the subpixel and the thicknesses of the metal isolation block and the light scattering structure or the light conversion structure, to obtain optimal light emitting efficiency. In other words, the metal isolation structure may be prepared by adjusting the angle, to obtain optimal light emitting efficiency.

Because in the MicroLED display screen provided in the foregoing embodiment, the metal reflection layer wraps around each subpixel, and the metal isolation structure is also prepared between the light scattering structure and the light conversion structure, more emitting light rays can be emitted from the MicroLED display screen, to provide a better light displaying effect.

An embodiment of this application provides a micro light emitting diode MicroLED display screen preparation method. The method includes: preparing a MicroLED array substrate, where a plurality of pixels are set in the MicroLED array substrate, and the plurality of pixels each include at least a first subpixel and a second subpixel; preparing a metal isolation structure, a light scattering structure, and a light conversion structure at a same layer of the MicroLED array substrate, where the metal isolation structure is prepared between the light scattering structure and the light conversion structure, the light scattering structure configured to scatter first emitting light generated by the first subpixel is prepared above the first subpixel, and the light conversion structure configured to convert second emitting light generated by the second subpixel is prepared above the second subpixel.

Further, the preparing a MicroLED array substrate includes: preparing a MicroLED array, where the MicroLED array includes a plurality of pixels, and the pixels each include the first subpixel and the second subpixel; depositing a dielectric layer on the MicroLED array; depositing a metal on an etched dielectric layer, to obtain a metal reflection layer wrapping around side surfaces and lower surfaces of the first subpixel and the second subpixel, where there is the deposited dielectric layer between the side surface of the subpixel and the metal reflection layer; and etching the metal reflection layer on the lower surface of the subpixel, to enable the metal reflection layer to form ohmic contact with an electrode above the metal reflection layer.

In some instances, after the preparing a MicroLED array substrate, the method further includes: bonding the MicroLED array substrate on a circuit backplane, to enable the circuit backplane to drive the first subpixel to generate the first emitting light and drive the second subpixel to generate the second emitting light.

For example, the display screen may be prepared by using a method provided in FIG. 5. FIG. 5 is a schematic flowchart of a MicroLED display screen preparation method according to an embodiment of this application. As shown in FIG. 5, the method includes the following steps.

S10: Prepare a MicroLED array substrate.

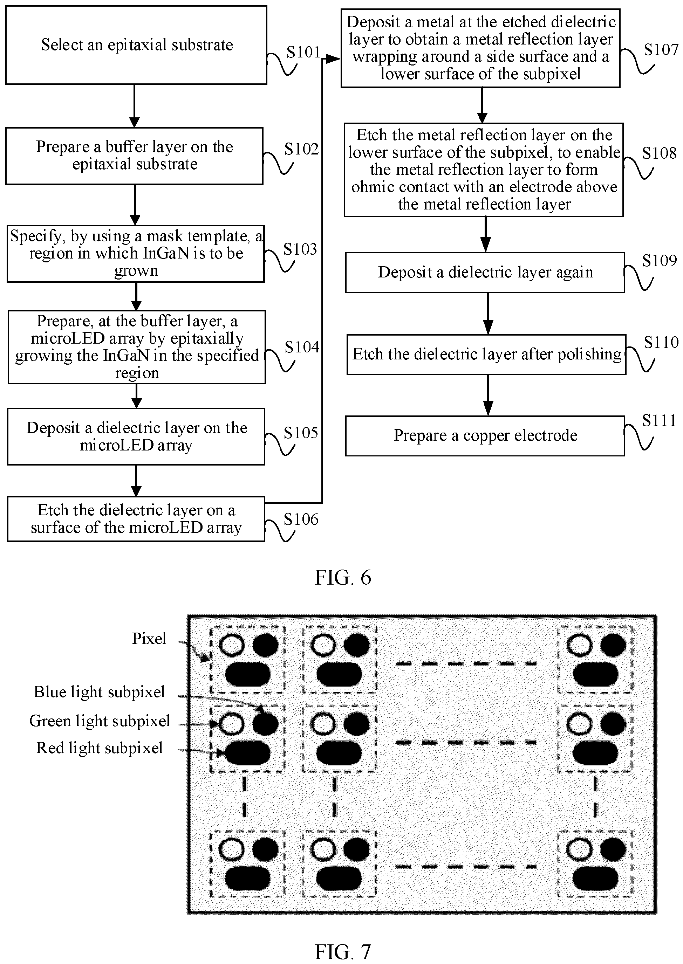

A step of preparing the MicroLED array substrate may be shown in FIG. 6. FIG. 6 is a schematic flowchart of a MicroLED array substrate preparation method according to an embodiment of this application.

S101: Select an epitaxial substrate.

A MicroLED array may be prepared by using a selective region epitaxial growth technology. The epitaxial substrate, for example, an epitaxial substrate of a material such as a sapphire, natural gallium nitride, gallium nitride GaN, silicon, or silicon carbide SiC, is prepared first.

S102: Prepare a buffer layer on the epitaxial substrate.

S 103: Specify, by using a mask template, a region in which InGaN is to be grown.

S104: Prepare, at the buffer layer, the MicroLED array by epitaxially growing the InGaN in the specified region.

The prepared MicroLED array may include M*N pixels, each pixel includes three subpixels: red, green, and blue, and each pixel may include one first subpixel and two second subpixels, or two first subpixels and one second subpixel. For how to allocate the subpixels, refer to the foregoing example. Details are not described herein again. FIG. 7 is a schematic diagram of a structure of pixel arrangement of the MicroLED array. As shown in FIG. 7, the MicroLED array has M pixels in a horizontal direction, and has N pixels in a vertical direction, where N and M are positive integers. For example, a video displaying format 1080P usually corresponds to 1920 pixels in the horizontal direction and 1080 pixels in the vertical direction. That is, in a MicroLED array in 1080P, M = 1920 and N = 1080. During preparation, a size of each pixel may be controlled between 2 µm and 5 µm. For example, when a pixel spacing of the prepared MicroLED array is 3 µm, the size of each pixel may be prepared to be about 2.5 µm. When a subpixel of the MicroLED array is allocated, considering that light conversion efficiency of red light is low, increasing an area of a red light subpixel can ensure overall brightness of the display screen. Therefore, as shown in FIG. 7, a blue light subpixel with a diameter of about 0.8 µm, a green light subpixel with a diameter of about 0.8 µm, and a red light subpixel that is in a shape of a rounded rectangle and with a width of about 0.8 µm and a length of about 2 µm may be prepared. The MicroLED array may be prepared by using the selective region epitaxial growth technology. To be specific, on a same epitaxial substrate, for example, on the epitaxial substrate of the material such as the sapphire, natural gallium nitride, gallium nitride GaN, silicon, or silicon carbide SiC, an indium gallium nitride InGaN MicroLED is epitaxially grown in the specified region by using the mask template. An InGaN material has good mechanical stability and a short hole diffusion length, can be compatible with a green light InGaN MicroLED and a blue light InGaN MicroLED, and is a preferred choice for preparing a red light MicroLED. In this embodiment of this application, descriptions are provided by using an example in which the red light MicroLED is obtained by performing light conversion after the blue light InGaN MicroLED is prepared. Further, the blue light InGaN MicroLED and the green light InGaN MicroLED may be prepared at one time through epitaxial growth in the specified region, or the blue light InGaN MicroLED and the green light InGaN MicroLED may be respectively prepared by selecting the specified region for two times for epitaxial growth. The blue light InGaN MicroLED and the green light InGaN MicroLED may be prepared at one time, as shown in FIG. 7. A to-be-prepared green light InGaN MicroLED is correspondingly specified in M*N regions that are on the epitaxial substrate and that are corresponding to a position of the green light subpixel, and the blue light InGaN MicroLED is correspondingly specified in 2*M*N regions that are on the epitaxial substrate and that are corresponding to positions of the blue light subpixel and the red light subpixel. Before the blue light InGaN MicroLED and the green light InGaN MicroLED are specified, the buffer layer may be grown on the substrate. After the blue light InGaN MicroLED and the green light InGaN MicroLED are specified, the green light InGaN MicroLED is grown in a region in which the green light InGaN MicroLED is to be prepared, and the blue light InGaN MicroLED is grown in a region in which the blue light InGaN MicroLED is to be prepared. Preparing the blue light InGaN MicroLED and the green light InGaN MicroLED respectively by selecting the region for two times for epitaxial growth may be separate preparation performed after the region is specified for two times. Details are not described herein again. After the InGaN is grown, the MicroLED array substrate is prepared.

A prepared material may alternatively be an ultraviolet light material or the like, which is not limited in this example.

S105: Deposit a dielectric layer on the MicroLED array.

After the MicroLED array is prepared, passivation protection needs to be performed on a surface of the MicroLED. Usually, a dielectric layer of silicon dioxide SiO2 or silicon nitride SiNx is prepared through chemical vapor deposition, where the dielectric layer is also referred to as a passivation layer. Surface passivation on each subpixel of the MicroLED array and electrical isolation between the subpixels can be implemented simultaneously.

S 106: Etch the dielectric layer on a surface of the MicroLED array.

Etching the dielectric layer on the surface of the MicroLED to expose an anode region of the MicroLED is a preparation for subsequently depositing a metal reflection layer on the surface of the MicroLED, so that the metal reflection layer can contact with the subpixel of the MicroLED array. It should be noted that an example in which the MicroLED array is powered through co-cathode driving is used herein. If a MicroLED array powered through co-anode driving is to be prepared, the dielectric layer is etched to expose a cathode region of the MicroLED.

S107: Deposit a metal at the etched dielectric layer to obtain a metal reflection layer wrapping around a side surface and a lower surface of the subpixel.

An example in which the MicroLED array is powered through co-cathode driving is used. Physical vapor deposition is performed on a layer of an anode metal in the exposed anode region of the MicroLED. The metal may be Ag, Al, Ti, or the like. After the metal is deposited, the metal is in contact with P-type gallium nitride GaN of the MicroLED, and wraps around the MicroLED. Pixel optical isolation is performed on the MicroLED. As shown in FIG. 2, the deposited metal is in contact with the P-type gallium nitride GaN of each subpixel in the MicroLED, and wraps around each subpixel. Because the metal layer has a reflection function, light emitted from a part wrapped by the metal layer is reflected back to the subpixel, then uniformly passes through a position at which graphical processing is performed, and is emitted based on an optical path required by the MicroLED. With blocking of the metal reflection layer, light crosstalk between the subpixels does not occur, and effective pixel optical isolation can be performed on the MicroLED. Because only the dielectric layer on the surface of the MicroLED array is etched in S106, the dielectric layer deposited in S 105 further exists between the side surface of the subpixel and the metal reflection layer, and can still play a passivation protection function. If the MicroLED array is powered through co-anode driving, the metal should be in contact with N-type gallium nitride GaN of each subpixel by using the exposed cathode region, where the metal is equivalent to a cathode metal. For a power supply manner and a contact manner of the MicroLED, refer to the conventional technology, and details are not described herein.

S108: Etch the metal reflection layer on the lower surface of the subpixel, to enable the metal reflection layer to form ohmic contact with an electrode above the metal reflection layer.

The MicroLED uses a co-cathode driving manner, and graphical processing needs to be performed on the anode metal to avoid an anode short circuit in a subsequent process of the MicroLED. The MicroLED uses a co-anode driving manner, and graphical processing needs to be performed on the cathode metal. In this embodiment of this application, an example in which graphical processing is performed on the anode metal is used for description.

S109: Deposit a dielectric layer again.

The anode metal needs to be protected by using a dielectric material after graphical processing is performed, and gaps between the subpixels of the MicroLED array also need to be filled, so that a subsequent process is not affected. SiO2 or SiNx can still be prepared through chemical vapor deposition. A thickness of the deposited dielectric layer this time is about 2 µm to 3 µm.

S110: Etch the dielectric layer after polishing.

The surface of the MicroLED array may be flattened by polishing the dielectric layer. In this step, a mature chemical mechanical polishing (Chemical Mechanical Polishing, CMP) technology in a semiconductor process may be used, and details are not described in this embodiment of this application. The dielectric layer is etched to expose the anode metal of the MicroLED array, so that a subsequently prepared copper electrode forms ohmic contact with the anode metal.

S111: Prepare the copper electrode.

Usually, the electrode is the copper electrode. The copper electrode may be prepared by using a physical vapor deposition method. After the copper electrode is prepared, the copper electrode may be further punctured and polished. Only a copper electrode corresponding to the MicroLED anode metal is reserved during puncturing, and a surface of the copper electrode is smoother through polishing.

The MicroLED array substrate is obtained after the foregoing steps S101 to S111 are completed.

S20: Prepare a circuit backplane.

Usually, the preparation of the circuit backplane may be preparation of a backplane having a CMOS drive circuit. The circuit backplane is prepared based on a silicon semiconductor technology. A copper electrode of the CMOS drive circuit is prepared at a top layer of the circuit backplane, a dielectric layer is deposited around the copper electrode, and the CMOS drive circuit is prepared by using a mature semiconductor process. Details are not described in this embodiment of this application.

S30: Bond the prepared MicroLED array substrate with the circuit backplane.

Bonding the MicroLED array substrate with the circuit backplane means aligning the copper electrode of the CMOS drive circuit with a basic anode copper electrode of the MicroLED, and connecting copper electrodes in the MicroLED array substrate and the circuit backplane through copper atom diffusion to form an electrical connection. A dielectric layer is deposited in each of a non-electrode region of the MicroLED array substrate and a non-electrode region of the circuit backplane. The dielectric layer also undergoes a chemical reaction under a specific temperature and pressure, so that the two interfaces are fused to implement bonding between the MicroLED array substrate and the drive circuit backplane. In the bonded MicroLED array substrate and circuit backplane, the epitaxial substrate needs to be removed. Different substrates have different removing processes. If the epitaxial substrate of the sapphire is used, laser removing is usually used. If the substrate of the silicon is used, CMP thinning removing may be used.

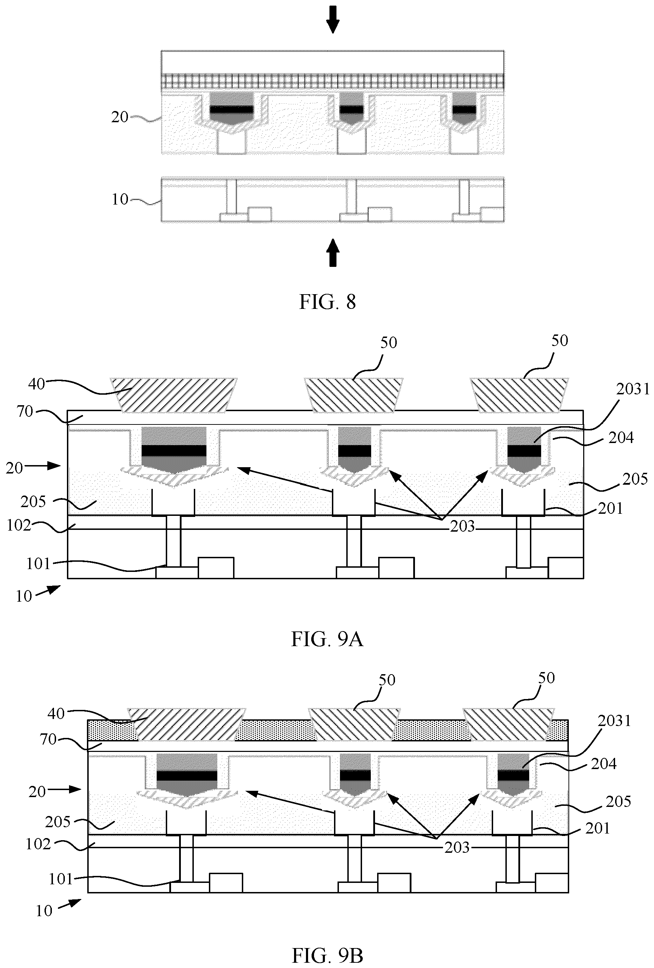

After the substrate is removed, the circuit backplane is located below the MicroLED array substrate. A structure is shown in FIG. 8. FIG. 8 is a bonding diagram of the circuit backplane and the MicroLED array substrate according to an embodiment of this application. In a subsequent preparation step, a next step of preparation is performed above the MicroLED array from which the epitaxial substrate is removed.

S40: Deposit a transparent electrode.

For example, the MicroLED array uses a co-cathode structure. After the epitaxial substrate is removed, a transparent cathode is prepared on an upper surface of the MicroLED array, and at least one of materials such as indium tin oxide, aluminum zinc oxide, silver nanowire, a carbon nanotube, and a metal grid may be used. As shown in FIG. 2, transparent cathodes are prepared on upper surfaces of all subpixels of the MicroLED. The MicroLED array using the co-cathode structure may be deduced by analog. When the transparent cathode is prepared, for example, after the transparent cathode is prepared by using the indium tin oxide, a layer of the metal grid may be further prepared at an upper layer, to reduce a resistance of the cathode.

S50: Deposit a metal isolation structure above the transparent electrode.

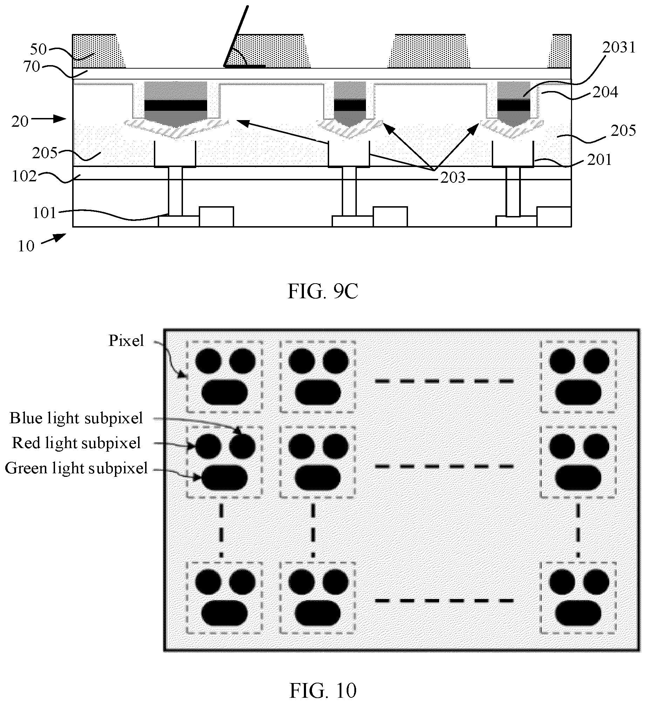

The co-cathode MicroLED array is still used for description. A metal isolation structure preparation method of a co-anode MicroLED array may be deduced by analog, and the transparent cathode is prepared. FIG. 9A is a preparation flowchart of preparing a metal isolation structure according to an embodiment of this application. FIG. 9B is a preparation flowchart of preparing the metal isolation structure according to an embodiment of this application. FIG. 9C is another preparation flowchart of preparing the metal isolation structure according to an embodiment of this application. Steps of preparing the metal isolation structure are respectively shown in FIG. 9A, FIG. 9B, and FIG. 9C. A specific preparation process of preparing the metal isolation structure may be implemented by using any one of the following three methods.

Method 1: A metal of 1 µm to 3 µm may be first prepared on a transparent cathode through physical vapor deposition, and the metal may use a material having a light reflection feature, such as aluminum, copper, titanium, or molybdenum. Then, a photoresist is spin-coated at a deposited metal layer, and a corresponding pattern is prepared through exposing and developing for subsequent metal etching. The corresponding pattern has been preset based on driving and a displayed color of each subpixel, and is used for subsequent displaying. In addition, because concave-convex is formed after metal etching, the concave-convex may also be used as a metal grid to reduce a resistance of the transparent cathode. Finally, the metal isolation structure may be etched. Chemical wet etching or ion dry etching may be used for etching. In this embodiment of this application, ion dry etching is preferred, to implement pixel structures at different angles.

Method 2: A metal of 1 µm to 3 µm may be first prepared on a transparent cathode in an electroplating manner, and the metal may still use a material having a light reflection feature, such as aluminum, copper, titanium, or molybdenum. A photoresist is spin-coated at a deposited metal layer, and a corresponding pattern is prepared through exposing and developing for subsequent metal etching. Finally, the metal isolation structure may be etched. Chemical wet etching or ion dry etching may be used for etching. In this embodiment of this application, ion dry etching is preferred, to implement pixel structures at different angles.

Method 3: A photoresist may be first spin-coated on a transparent cathode, and an inverted trapezoid structure is prepared through exposing and developing in a MicroLED region, namely, a position above each subpixel, as shown in FIG. 9A. Then, a metal of 1 µm to 3 µm is deposited in an electroplating manner. A metal material is the same as above. The metal may use a material having a light reflection feature, such as aluminum, copper, titanium, or molybdenum. The deposited metal isolation structure is shown in FIG. 9B. After electroplating is completed, the photoresist is removed to form the metal isolation structure, to form the structure shown in FIG. 9C.

Further, as shown in FIG. 9C, there is inverted trapezoid space above each subpixel. A metal isolation structure section between the space may be considered as a trapezoid. An angle β of an angle of inclination between a side edge and a bottom edge of the trapezoid may range from 15° to 80°. A specific value may be determined based on a size of the subpixel below the space, a thickness of the metal isolation structure, and optimal light emitting efficiency that can be obtained. The thickness of the metal isolation structure is the same as a thickness of a light scattering structure and a light conversion structure that are subsequently prepared.

After the metal isolation structure is prepared, the light conversion structure and the light scattering structure are prepared at a same layer. Different steps are performed based on whether light conversion needs to be performed on the subpixel, that is, whether the subpixel is the first subpixel or the second subpixel. If the subpixel is the first subpixel, and light conversion does not need to be performed, S60 is performed. If the subpixel is the second subpixel, and light conversion needs to be performed, S70 is performed. For example, each pixel in the MicroLED array includes one green light subpixel with a green light InGaN MicroLED, one blue light subpixel with a blue light InGaN MicroLED, and one red light subpixel with the blue light InGaN MicroLED. Light conversion does not need to be performed on the green light subpixel and the blue light subpixel, and therefore, step S60 is performed. Light conversion needs to be performed on the red light subpixel, and therefore, step 70 is performed.

S60: Prepare the light scattering structure above the first subpixel.

The thickness of the light scattering structure may be prepared to be 1 µm to 3 µm. First, the light scattering structure is prepared by doping a scattering particle material such as titanium dioxide or aluminum oxide into a transparent photoresist. Then, a material of the light scattering structure is spin-coated on the metal isolation structure. After spin-coating, a light scattering structure in a region other than a blue light subpixel region and a green light subpixel region, namely, a region covered by the metal isolation structure after 550, is removed through etching. Finally, the light scattering structure is obtained through baking and curing.

S70: Prepare the light conversion structure above the second subpixel.

The thickness of the light conversion structure may be prepared to be 1 µm to 3 µm. As shown in the foregoing example, the red light subpixel needs to convert, into red light, the blue light InGaN MicroLED grown in the red light subpixel, and a light conversion structure of the red light needs to be prepared above the subpixel. Steps are as follows: A light conversion material of the red light is spin-coated and may be a light conversion material of a cadmium selenide CdSe quantum dot, a light conversion material of an indium phosphate InP quantum dot, a light conversion material of a perovskite quantum dot, a phosphor material, or an organic light conversion material. The light conversion material of the CdSe quantum dot is preferred. After spin-coating, a light conversion material in a region other than a red light pixel region, namely, a region covered by the metal isolation structure after 550, is removed through etching. Then, the light conversion structure is obtained through baking and curing.

It should be noted that a diameter of the light conversion structure prepared above each second subpixel is slightly smaller than that of the subpixel, but is larger than that of grown blue light and green light InGaN MicroLEDs. For example, if the diameter of the InGaN MicroLED is 1.5 µm, the diameter of the light conversion structure is 1.8 µm, and the diameter of the subpixel is about 2.5 µm. There is no sequence between S60 and 570. After S60 and S70 are completed, S80 further needs to be performed.

S80: Prepare an encapsulation layer on the light scattering structure, the light conversion structure, and the metal isolation structure.

After the light scattering structure and the light conversion structure are prepared, an encapsulation layer of 20 nm to 200 nm may be prepared through chemical vapor deposition or atomic layer deposition. Silicon dioxide SiO2, silicon nitride SiNx, or aluminum oxide Al2O3 may be selected as a material of the encapsulation layer. The light scattering structure, the light conversion structure, and the metal isolation structure have the same thickness, and a surface may be smoothed. The encapsulation layer is prepared on the light scattering structure, the light conversion structure, and the metal isolation structure, so that the light conversion structure and the light scattering structure can be isolated from water vapor and oxygen in the air, to slow down aging speeds of the light conversion structure and the scattering layer.

In some instances, after the encapsulation layer is prepared, a microlens array may be further prepared, that is, step S90 is performed.

S90: Dispose one microlens at a position, at the encapsulation layer, corresponding to the light scattering structure or the light conversion structure disposed above each subpixel, where a plurality of microlenses form the microlens array.

After the encapsulation layer is prepared, a divergence angle of a pixel may be reduced by preparing the microlens array. In other words, collimation of a light ray is improved, so that more light rays are concentrated at a small angle for emitting.

After the foregoing steps of preparation are performed, the MicroLED display screen shown in FIG. 2 may be finally obtained.

An embodiment of this application may further provide a MicroLED display screen preparation method. Steps of the method are basically the same as those in the foregoing example. In S 10 of preparing a MicroLED array substrate, when a MicroLED array is prepared by epitaxially growing InGaN in a specified region, the method is slightly different from the foregoing preparation method.

The prepared MicroLED array may still include M*N pixels, and each pixel includes three subpixels: red, green, and blue. FIG. 10 is a schematic diagram of another structure of pixel arrangement of the MicroLED array according to an embodiment of this application. As shown in FIG. 10, common 1080P corresponds to 1920 horizontal pixels and 1080 vertical pixels. During preparation, a size of each pixel may be controlled between 2 µm and 5 µm. For example, when a pixel spacing of the prepared MicroLED array is 3 µm, the size of each pixel may be prepared to be about 2.5 µm. When a subpixel of the MicroLED array is allocated, a size of the subpixel adapts to conversion efficiency of a light conversion material in a light conversion structure corresponding to the subpixel. In other words, in consideration of conversion efficiency of red light or green light, different areas are allocated to ensure brightness of the entire display screen. For example, if light emitting efficiency of a light conversion material of the green light is low, an area of the green light subpixel may be set to the largest, as shown in FIG. 10. The blue light and red light subpixels are circles with diameters of about 0.8 µm, and the green light pixel is a rounded rectangle with a width of 0.8 µm and a length of about 2 µm. A MicroLED array of this specification can still be prepared by using a selective region epitaxial growth technology. To be specific, on a same epitaxial substrate, an indium gallium nitride InGaN MicroLED is epitaxially grown in a specified region by using a mask template. This embodiment of this application is described by using an example in which both red light and green light MicroLEDs are obtained by performing light conversion after a blue light InGaN MicroLED is prepared. Epitaxial growing may be performed in a specified region to prepare the blue light InGaN MicroLED. After InGaN is grown, the MicroLED array is prepared. Then, after S80 is completed based on the steps in the foregoing embodiment, the MicroLED display screen shown in FIG. 4 is obtained.

According to the MicroLED display screen and the preparation method provided in embodiments of this application, a metal reflection layer that can wrap around a side surface of a subpixel is provided, to effectively prevent light ray crosstalk between MicroLEDs. In addition, an isolation structure of a metal isolation structure between a light scattering structure and a light conversion structure is provided, to effectively prevent light ray crosstalk between the light scattering structure and the light conversion structure, and enable the display screen to have high brightness and fast heat dissipation at high pixel density. In addition, compared with some technologies, in the conventional technology, in which a reflection material needs to be repeatedly prepared and etched, in this application, a preparation process is simpler, and preparation difficulty and costs can be effectively reduced.

In the several embodiments provided in embodiments of this application, it should be understood that the disclosed structure of the micro display screen and steps of the preparation method may be implemented in other manners, and the described apparatus embodiments are merely examples.

The foregoing descriptions are merely specific implementations of embodiments of this application, but are not intended to limit the protection scope of embodiments of this application. Any variation or replacement readily figured out by a person skilled in the art within the technical scope disclosed in embodiments of this application shall fall within the protection scope of embodiments of this application. Therefore, the protection scope of embodiments of this application shall be subject to the protection scope of the claims.

## Claims

1. A micro light emitting diode display screen, comprising:
a micro light emitting diode array substrate, wherein a plurality of pixels are set in the micro light emitting diode array substrate, and the plurality of pixels each comprise at least a first subpixel and a second subpixel;
a light scattering structure, prepared above the first subpixel, and configured to scatter first emitting light generated by the first subpixel;
a light conversion structure, prepared above the second subpixel, and configured to convert second emitting light generated by the second subpixel; and
a metal isolation structure, prepared between the light scattering structure and the light conversion structure, wherein the light scattering structure, the light conversion structure, and the metal isolation structure are located at a same layer.

2. The display screen according to claim 1, wherein
a metal reflection layer wraps around side surfaces and bottom surfaces of the first subpixel and the second subpixel.

3. The display screen according to claim 1 or 2, further comprising:
a circuit backplane, bonded with the micro light emitting diode array substrate, and configured to: drive the first subpixel to generate the first emitting light and drive the second subpixel to generate the second emitting light.

4. The display screen according to any one of claims 1 to 3, wherein
each pixel comprises two first subpixels and one second subpixel, wherein one of the first subpixels is a green light subpixel on which a green light indium gallium nitride micro light emitting diode is prepared, the other one of the first subpixels is a blue light subpixel on which a blue light indium gallium nitride micro light emitting diode is prepared, and the second subpixel is a red light subpixel on which the blue light indium gallium nitride micro light emitting diode is prepared.

5. The display screen according to any one of claims 1 to 3, wherein
each pixel comprises one first subpixel and two second subpixels, wherein the first subpixel is a blue light subpixel on which a blue light indium gallium nitride micro light emitting diode is prepared, one of the second subpixels is a red light subpixel on which the blue light indium gallium nitride micro light emitting diode is prepared, and the other one of the second subpixels is a green light subpixel on which the blue light indium gallium nitride micro light emitting diode is prepared.

6. The display screen according to any one of claims 1 to 5, wherein
the micro light emitting diode array substrate comprises a plurality of electrodes electrically connected to the circuit backplane, the plurality of electrodes are connected to supply power, one first subpixel or one second subpixel is correspondingly prepared on each electrode, a dielectric layer is deposited between the side surfaces of the first subpixel and the second subpixel and the metal reflection layer, and the metal reflection layer on the bottom surfaces of the first subpixel and the second subpixel is connected to the electrode.

7. The display screen according to any one of claims 1 to 6, wherein the display screen further comprises:
an encapsulation layer, located on the light scattering structure, the light conversion structure, and the metal isolation structure that are located at the same layer.

8. The display screen according to claim 7, further comprising:
a microlens array, prepared on the encapsulation layer, wherein the microlens array comprises a plurality of microlenses, and each microlens is correspondingly disposed above the light scattering structure or the light conversion structure.

9. The display screen according to any one of claims 1 to 8, wherein
a size of the second subpixel adapts to conversion efficiency of a light conversion material in the corresponding light conversion structure.

10. The display screen according to any one of claims 1 to 9, further comprising:
a transparent electrode, deposited on the first subpixel and the second subpixel.

11. A micro light emitting diode preparation method, comprising:
preparing a micro light emitting diode array substrate, wherein a plurality of pixels are set in the micro light emitting diode array substrate, and the plurality of pixels each comprise at least a first subpixel and a second subpixel; and
preparing a metal isolation structure, a light scattering structure, and a light conversion structure at a same layer of the micro light emitting diode array substrate, wherein the metal isolation structure is prepared between the light scattering structure and the light conversion structure, the light scattering structure configured to scatter first emitting light generated by the first subpixel is prepared above the first subpixel, and the light conversion structure configured to convert second emitting light generated by the second subpixel is prepared above the second subpixel.

12. The method according to claim 11, wherein the preparing a micro light emitting diode array substrate comprises:
preparing a micro light emitting diode array, wherein the micro light emitting diode array comprises a plurality of pixels, and the pixels each comprise the first subpixel and the second subpixel;
depositing a dielectric layer on the micro light emitting diode array;
depositing a metal at an etched dielectric layer, to obtain a metal reflection layer wrapping around side surfaces and lower surfaces of the first subpixel and the second subpixel, wherein there is the deposited dielectric layer between the side surface of the subpixel and the metal reflection layer; and
etching the metal reflection layer on the lower surface of the subpixel, to enable the metal reflection layer to form ohmic contact with an electrode above the metal reflection layer.

13. The method according to claim 11 or 12, wherein after the preparing a micro light emitting diode array substrate, the method further comprises:
bonding the micro light emitting diode array substrate on a circuit backplane, to enable the circuit backplane to drive the first subpixel to generate the first emitting light and drive the second subpixel to generate the second emitting light.

14. The method according to any one of claims 11 to 13, wherein the preparing a micro light emitting diode array substrate comprises:
preparing a plurality of pixels that each comprise two first subpixels and one second subpixel, wherein preparing the two first subpixels comprises preparing one green light subpixel by growing a green light indium gallium nitride micro light emitting diode and preparing one blue light subpixel by growing a blue light indium gallium nitride micro light emitting diode, and preparing the second subpixel comprises preparing one red light subpixel by growing the blue light indium gallium nitride micro light emitting diode.

15. The method according to any one of claims 11 to 13, wherein the preparing a micro light emitting diode array substrate comprises:
preparing a plurality of pixels that each comprise one first subpixel and two second subpixels, wherein preparing the first subpixel comprises preparing one blue light subpixel by growing a blue light indium gallium nitride micro light emitting diode, and preparing the two second subpixels comprises preparing one red light subpixel by growing the blue light indium gallium nitride micro light emitting diode and preparing one green light subpixel by growing the blue light indium gallium nitride micro light emitting diode.

16. The method according to any one of claims 11 to 15, wherein after the preparing a micro light emitting diode array substrate, the method further comprises:
bonding the micro light emitting diode array substrate on the circuit backplane, wherein a plurality of electrodes connected for power supply in the micro light emitting diode are electrically connected to the circuit backplane, one first subpixel or one second subpixel is correspondingly prepared on each electrode, the dielectric layer is deposited between the side surfaces of the first subpixel and the second subpixel and the metal reflection layer, and the metal reflection layer on the bottom surfaces of the first subpixel and the second subpixel is connected to the electrode, to enable the circuit backplane to drive the first subpixel and the second subpixel to emit light.

17. The method according to any one of claims 11 to 16, wherein after the preparing a metal isolation structure, a light scattering structure, and a light conversion structure at a same layer of the micro light emitting diode array substrate, the method further comprises:
preparing an encapsulation layer on the light scattering structure, the light conversion structure, and the metal isolation structure that are located at the same layer.

18. The method according to claim 17, wherein after the preparing an encapsulation layer on the light scattering structure, the light conversion structure, and the metal isolation structure that are located at the same layer, the method further comprises:
disposing one microlens at a position that is at the encapsulation layer and that is corresponding to the light scattering structure or the light conversion structure, wherein a plurality of microlenses form a microlens array.

19. The method according to any one of claims 11 to 18, wherein
a size of the second subpixel adapts to conversion efficiency of a light conversion material in the corresponding light conversion structure.

20. The method according to any one of claims 11 to 19, wherein before the preparing a metal isolation structure, a light scattering structure, and a light conversion structure at a same layer of the micro light emitting diode array substrate, the method further comprises:
depositing a transparent electrode on the first subpixel and the second subpixel.

21. The method according to claim 20, wherein the preparing a metal isolation structure comprises:
preparing the metal isolation structure on the transparent electrode through physical vapor deposition;
preparing the metal isolation structure on the transparent electrode in an electroplating manner; or
spin-coating a photoresist on the transparent electrode, preparing inverted trapezoid structures above the micro light emitting diode array through exposing and developing, and preparing the metal isolation structure between the inverted trapezoid structures in an electroplating manner.
